# EUROPEAN PATENT APPLICATION

(11) **EP 0 569 688 A1**
(43) Date of publication of application: **18.11.1993**
(21) Application number: 93104411.9
(22) Date of filing: 18.03.1993
(51) Int. Cl.: H04B 7/005, H03G 3/20

(54) **Method and apparatus for fading compensation for TDMA-receivers**

(30) Priority: 29.04.1992 EP 92107275
(71) Applicant: Hagenuk Telecom GmbH, 24118 Kiel (DE)
(72) Inventor: Fisker, Soren, DK-9220 Aalborg (DK)
(74) Representative: Hansmann, Dierk, Dipl.-Ing.

(57) **Abstract**

The invention relates to a method and an apparatus for fading compensation for a TMDA-receiver. The occurence of a burst of data in a received signal is detected. The power level of the received signal is determined. It is compared to a reference power level. From that controlled parameter for adjusting the received signals power level is derived. Adjusting is done with a first small time constant during arrival of the first bits and with the bigger time constant afterwards.

## Description

This invention relates to a method and an apparatus for fading compensation for a TDMA-receiver. As fading compensation herein the compensation of a slow change in the level of a TDMA signal during one slot is defined. More specifically it relates to fading compensation for a TDMA-receiver used for the GSM (Group Special Mobile) system for a Pan-European Mobile Telephone System (see for example Electronics and Communication Engineering Journal Jan/Feb. 1989 vol. 1, no. 1, p. 7-13, "Pan-European Cellular radio", D. M. Balston, which is explicitely incorporated herein by reference). It shall be also used for the oncomming 1.8 GHz-sytem.

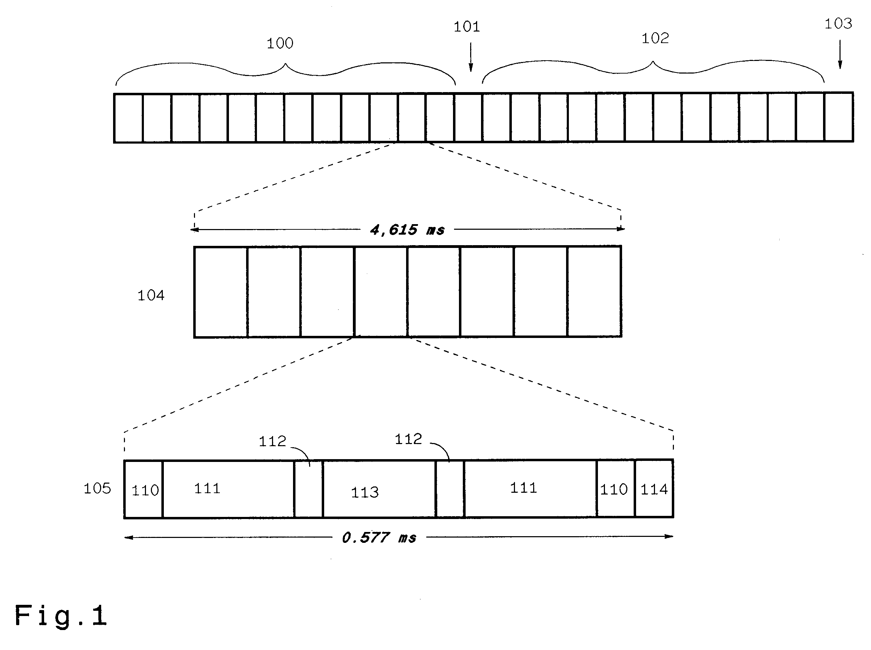

In the GSM system, data to be transmitted is modulated on to a 900 MHz carrier signal by a Gaussian minimum shift-keying technique (GMSK) (GSMrec.05.04). Frequency channels are provided at a spacing of 200 kHz and data is transmitted on each channel at a total rate of 270.833 kbit/s. In each channel data are transmitted in a TDMA (Time Division Multiple Access) (GSMrec.05.02) technique. In this technique as used in the GSM system (cf. Fig. 1) each frame of 4.615 ms duration contains 8 slots (bursts) of data, each slot having a duration of 0,577 ms including a guard period. The expression burst herein is used for a slot in which data for a GSM terminal or base station in an established communication link for data exchange is contained.

Prior art has been well aware of problems arising in receivers for TDMA systems and especially for the GSM system. These problems arise from a strongly varying signal strength due to which the input dynamic range may be as large as 100 db. Conventionally this is brought into the limited dynamic range of an analog to digital converter. For this different techniques have been put forward.

According to EP 0 411 756 A1 the receiver must not only operate correctly in a traffic mode when data are coming in, in a slot reserved for data hand over, for the terminal or base station but also in a monitor mode to monitor a new base station to ascertain whether it is a candidate for hand over. In the traffic mode the incoming signal is adjusted by a gain or attenuation which is constant for a time slot and which is based on a measurement made during a preceding time period. In the monitor mode the adjustment is memorised as well and is employed for subsequent readings.

According to EP 0 371 700 A2 a retained previous adjustment is used to adjust the receiver. The adjusted signal from the receiver is then used to calculate an adjustment for the future time slot. The adjustment remains unchanged for the actual slot which is under consideration. This means that the adjustment for the actual slot (burst) is based on old bursts which are at least seven slots old. From burst to burst especially in a multitpath environment like GSM the level can change as much as 30 dB (frequency hopping).

A similar solution is described in US 475 7502, where the adjustment is used at least for the slot itself unchanged. None of these techniques enables fading compensation. The problem of fading has not even been discunes so for.

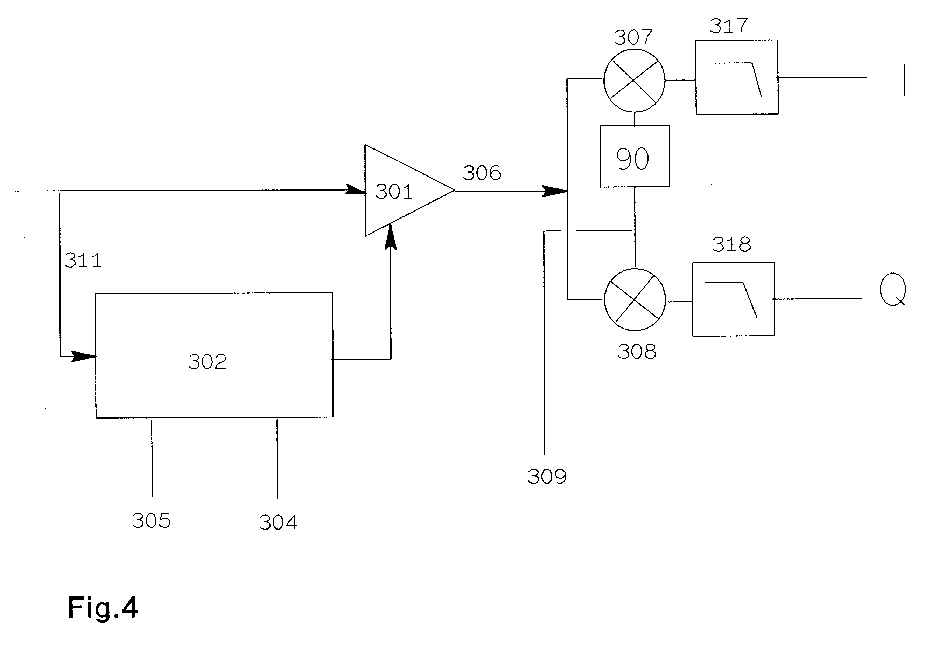

Method an apparatus of the invention are explained by reference to enclosed Fig. 1 - 11.
- Fig. 1: shows the TDMA structure.
- Fig. 2: shows schematically the time behaviour of the power level of an RF- or IF-TDMA-signal or its corresponding baseband signal in a slot (burst).
- Fig. 3: shows schematically a method and apparatus for fading compensation for TDMA receivers with the regulation circuit for fading compensation in a feedback from IF to IF configuration.
- Fig. 4: shows schematically a method and apparatus for fading compensation for TDMA receivers with the regulation circuit in a feedforward from IF to IF configuration.
- Fig. 5: shows schematically a method and apparatus for fading compensation for TDMA receivers with the regulation circuit in a feedback from baseband to IF configuration.
- Fig. 6: shows schematically a method and apparatus for fading compensation for TDMA receivers with the regulation circuit in a feedback from digital baseband to IF configuration.
- Fig. 7: shows schematically a method and an apparatus for fading compensation for TDMA receivers with the regulation circuit in an feedback from analog baseband to analog baseband configuration.
- Fig. 8: shows schematically a method and an apparatus for fading compensation for TDMA receivers with the regulation circuit in a feedback from digital baseband to analog baseband configuration.
- Fig. 9: shows schematically a method and an apparatus for fading compensation for TDMA receivers with the regulation circuit in a feedforward from analog baseband to analog baseband configuration.
- Fig. 10: shows schematically a configuration with an analog regulation circuit in a TDMA receiver.
- Fig. 11: shows schematically a test setup for a device using a method for fading compensation.

As shown in Fig. 1 the TDMA technique uses a multiframe structure with 12 traffic frames 100,102 interleaved by control frames 101,103. For explanatory reasons only a sequence of two traffic frames 100,102 is shown. Each of the frames 104 consists of eight slots 0-7. Each of the slots 105 as shown here for slot 3 contains tail bits 110, bits of coded data 111, control bits 112, bits for a training sequence 113 and a guard period 114.

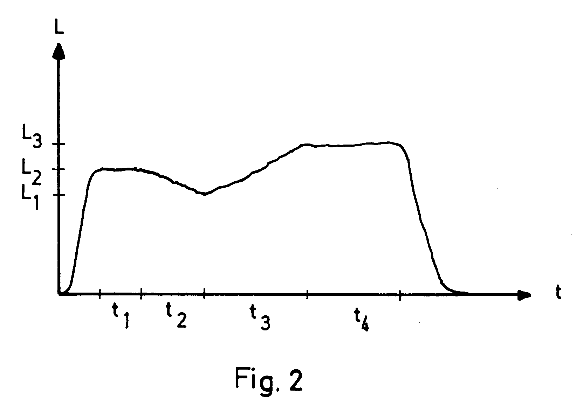

The problem of fading is explained herein with reference to Fig. 2. It is shown the level L as function of time t of a TDMA slot. The time t₅ is smaller than 0,577 ms. During t₁ the signal has a level L₁ and it starts to change slowly at the beginning of t₂. Another period of slow change of the level is t₃. Both periods t₂ an t₃ are by definition herein described as fading periods during which fading occurs. The signal might for explanatory reasons end up during t₄ at a level L₃. The problem now is, that the dynamic range L₂ and L₂ to L₃ must fit at any time in the slot (burst) in the limited dynamic range of the receiver in order not to loose information. Especially for the GSM system this is essential as any lost bit in the receivers A/D converter might cause heavy distortions in the speech codec. As conventionally the adjustment is only done at the very beginning of t₁ and remains constant from then on, the conventional techniques represent no solution to the problem of fading.

Moreover the adjustment which is determined from the beginning of t₁ might be wrong either due to noise spikes or due to not catching the correct beginning of the burst because of considerable delay spread in a multipath environment.

One solution would be to make a first (coarse) adjustment at the beginning of t₁, digitizing and storing the slot as whole as sample to be contemplated upon while waiting for the next burst. But this for the applications envisaged presently could be too power consuming and it may be quite costly due to the need of additional storage capacitiy. Additionally in this case further problems in determining the power of the received signal would arise, as due to GMSK neither of the quadrature phases, taken alone, is proportional to the received signal power.

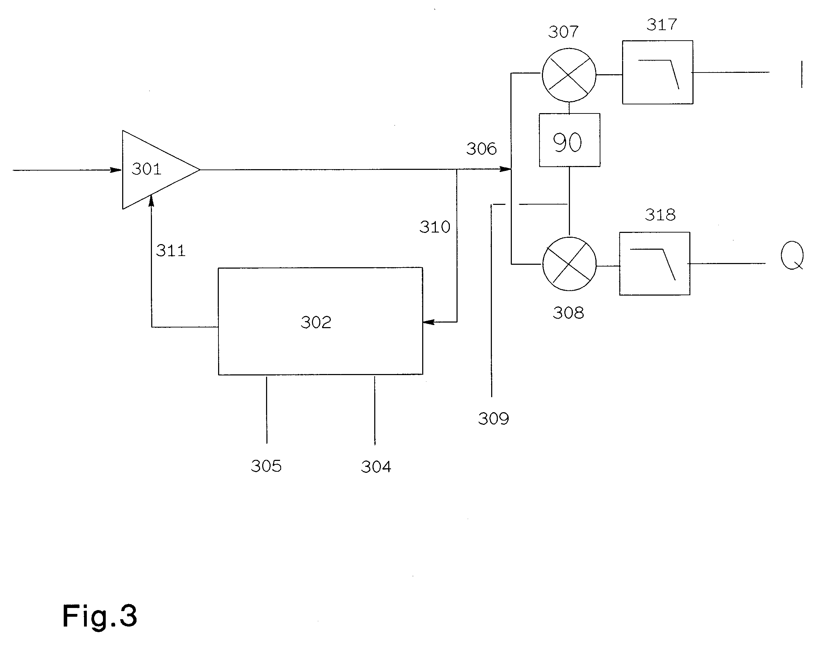

In Fig. 3 an IF signal as delivered by a standard RF-front for the reception of a TDMA signal (not shown) is passes to an adjusting device 301 (preferably a VCA).

The adjusting device 301 is connected to a regulation circuit 302 which can be analog or digital for fading compensation. The occurrence of a burst is detected from I- and Q-signals by a processing unit (not shown). The regulation circuit 302 performs the detection of the power level, compares the level to a reference level which may be adjusted during production via a set reference level device connected at live 304. The regulation circuit 302 determines a control parameter for the adjusting device 301 to adjust the received signal especially at the IF stage. By adjusting the received signal the adjustment of any signal derived from the signal as received by the antenna is defined. Thus the received signal could be an RF or a corresponding IF- or baseband signal.

According to the invention the received signal's power level (the power level more especially of the RF, IF, baseband) is adjusted with a first small time constant during the arrival of the first bits of the determined occurrance of a burst and is adjusted with a second, bigger time constant after the arrival of the first bits of the determined occurrence of a burst. The first and the second time constant, especially the switching between the time constant is controlled via line 305 which is connected to a not shown processing unit.

The adjusted IF signal is passed via line 306 to mixers 307, 308 connected via line 309 to a local oscillator (not shown) to give in-phase signals I and quadrature signals Q which are low-pass-filtered in 317, 318. According to a more special method and apparatus for fading compensation for a TDMA signal the regulation circuit 302 is connected in a feedback loop especially from IF to IF via lines 310, 311.

Perferably the regulation circuit in this case is designed to perform the detecting of the power level, the comparing of the detected power level with a predetermined reference level and the determining of the control parameter in an analog way.

Perferably the step of determing the occurrence of a burst essentially consists of synchronising the receiver with the transmitted TDMA signal via the I- and Q-signals by a not shown processing unit.

The step of detecting the power level of the received signal preferably consists of essentially measuring the average ac-level of the signal.

The steps of comparing the detected power level of the received signal with a predetermined reference level and determining a control parameter from said comparison which is fed via line 311 to adjusting device 301 essentially consists preferably of integrating the difference between the detected power level and the reference power level in the regulation circuit 302.

Preferably via control-line 305 the regulation circuit 302 is switched to the small time constant after an occurred burst is finished on a default basis, that means, before the burst is expected to arrive.

The adjustment of the received signal with the second, bigger time constant, as controlled by line 305, is preferably done by switching to said bigger time constant after the occurrence of a burst and after the maximum expectable delay spread caused by varying multi-path environments. The occurrence of a burst is predictable due to synchronisation performed by the not shown processing unit via I- and Q-signals.

Most preferably the regulation circuit includes a voltage following device for the network of the bigger time constant so as to make sure that the comparison sets off with the same voltage as in the network for the smaller time constant when the switching is done.

Especially the fading compensation in regulation circuit 302 is achieved by adjusting an IF digitally. For this purpose the detecting the power level is performed analog and the comparing of the detected power level to the reference level as well as the determining of the control parameter is performed digitally. This is done preferably in a feedback loop which especially feeds back the IF signal.

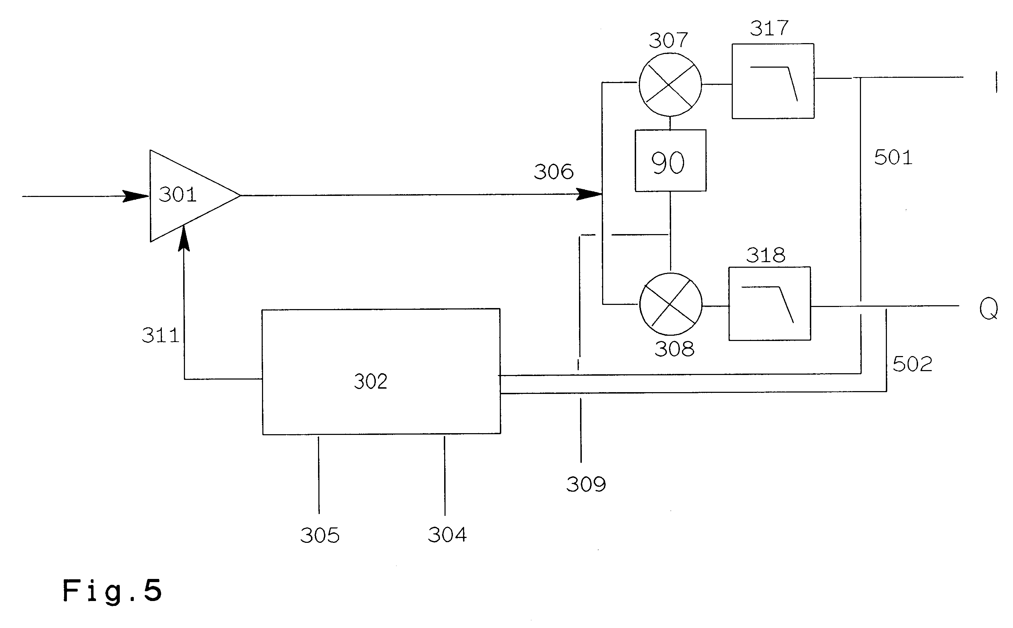

In Fig. 5 the IF signal is adjusted by adjusting device 301 and regulation circuit 302 in a feedback loop from baseband (I- and Q-signals) via lines 501, 502 to the IF signal via line 311. Regulation circuit 302 may operate digitally or analog.

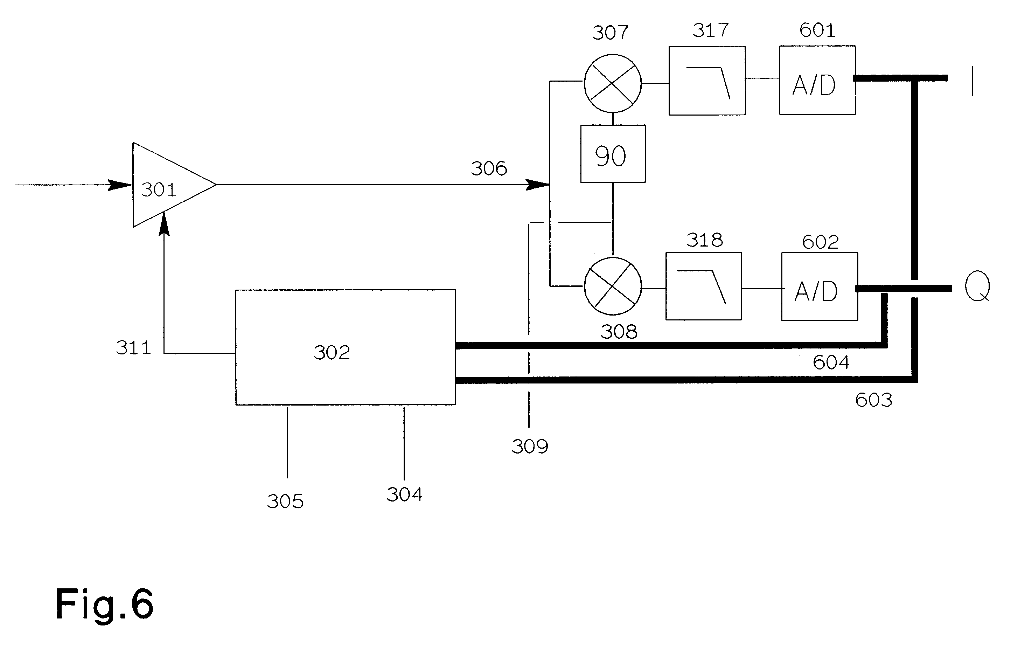

According to a preferred setup the method for fading compensation as shown in Fig. 6 uses a feedback loop for adjusting device 301 and regulation circuit 302 from digital baseband via lines 603, 604 in connection with A/D conversion 601, 602 to the IF signal via line 311. Fading compensation in regulation circuit 302 may operate digitally or analog.

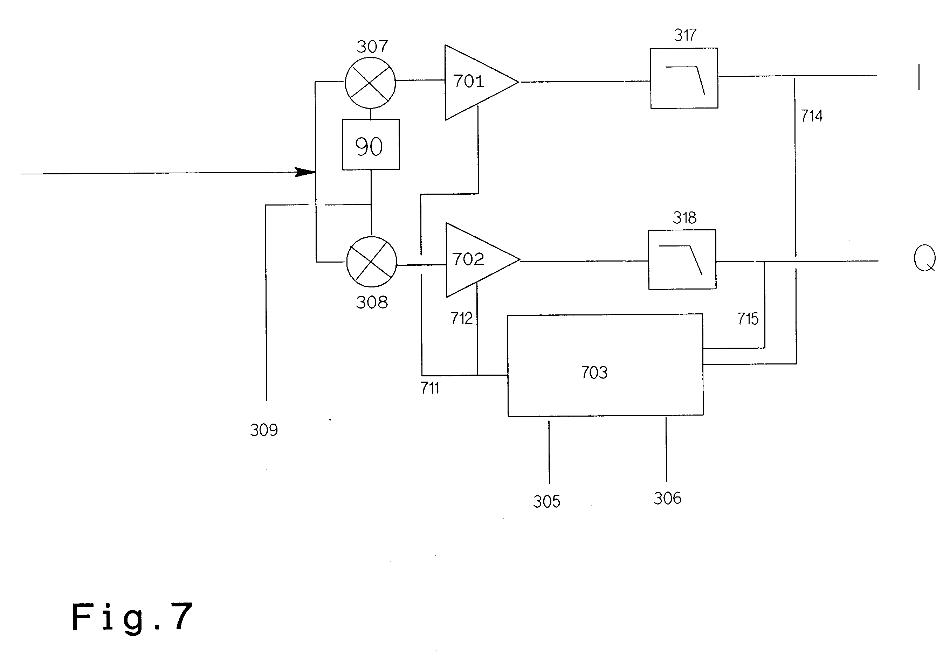

In Fig. 7 the received signals power level is adjusted o n baseband. For this by mixers 307, 308 connected to a local oscillator (not shown) via line 309 and low-pass-filtering 317, 318 in-phase-signals I and quadrature-signals Q are obtained (baseband signal). Regulation circuit 703 performs similar steps as described above for regulation circuit 302. By adjusting devices 701, 702 controlled by the regulation circuit 703 via lines 711, 712 the I- and Q-signals are adjusted. The regulation circuit may act analog or digitally.

With an analog working regulation circuit it is preferred to perform analog all the steps of detecting the power level, comparing the power level, determining the control parameter.

Via lines 714, 715 the regulation circuit 703 is coupled in a feedback loop from analog baseband.

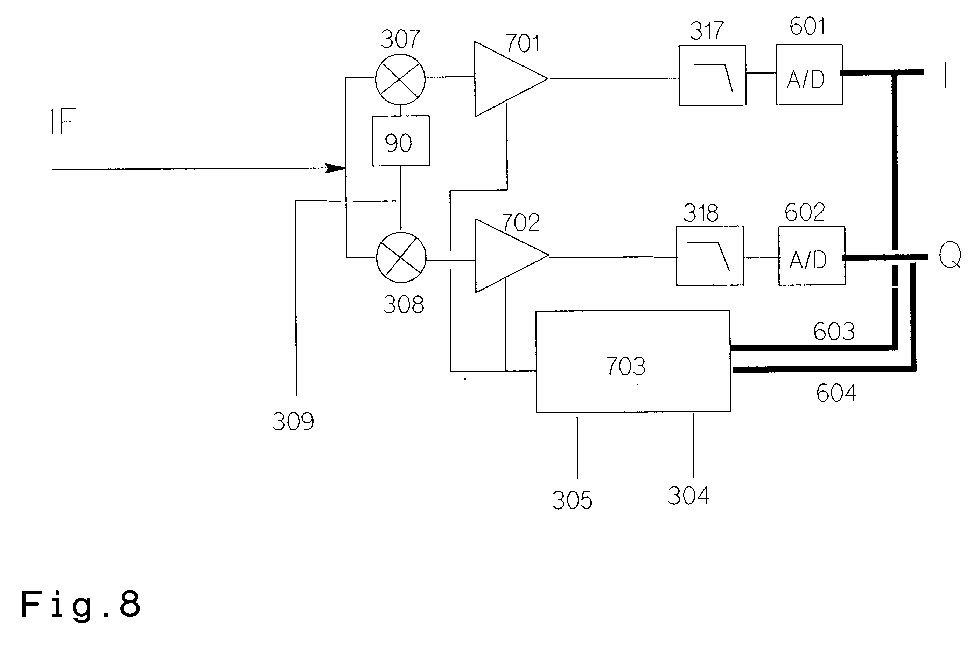

Preferably the regulation 703 is coupled in a feedback loop from a digital baseband via lines 603, 604 connected to A/D convertes 601, 602 in Fig. 8.

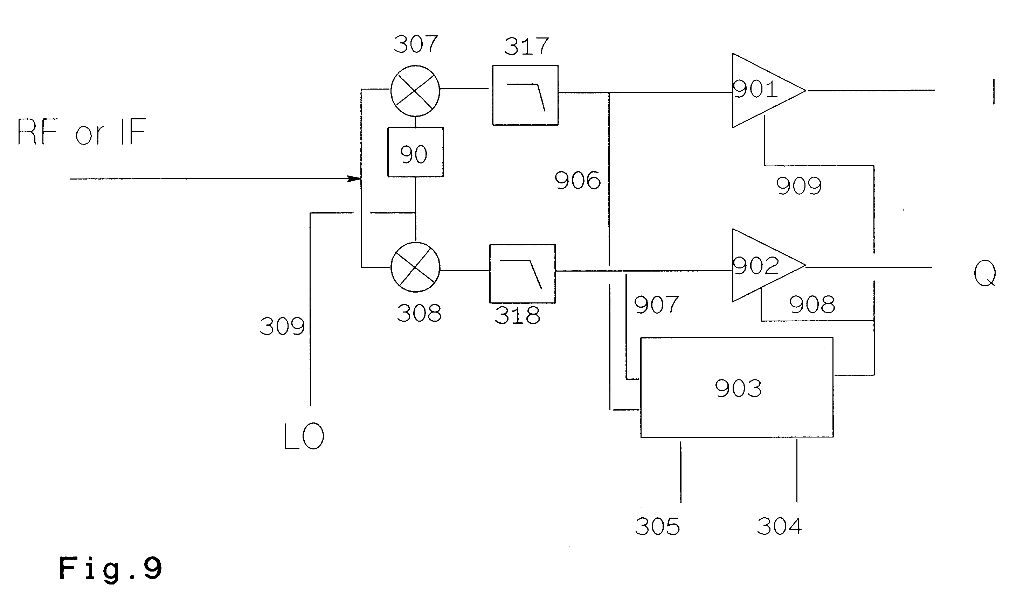

As shown in Fig. 9 for the regulation circuit 903 also a feedforward technique in the baseband can be used. Regulation circuit 903 works on signals coming in via lines 906, 907 and controlls adjusting devices 901, 902 via lines 908, 909.

In the case of a digitally working regulation circuit 703 in the baseband (I- and Q-signals) the steps of comparing the power level and determining the value of the control parameter are performed digitally while the step of detecting the power level is performed analog. In this case as shown in Fig. 7 a coupling of the regulation circuit 703 in a feedback loop is preferred. Most preferably the regulation circuit 703 then is coupled in a feedback loop from a digital baseband via lines 814, 815 connected t A/D converters 601, 602 as shown in Fig. 8.

With a digitally working regulation circuit 903 in the baseband also a feedforward technique as shown in Fig. 9 may be used.

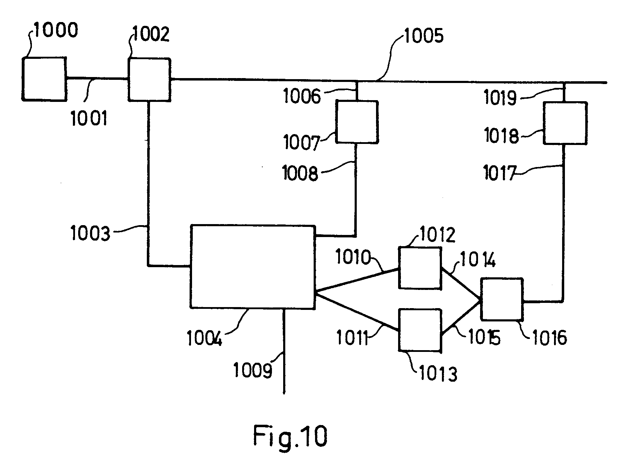

In Fig. 10 an example for an analog regulation circuit for an apparatus for fading compensation in a TDMA receiver is shown schematically. The receiver includes a receiving device 1000 which normally incorporates an antenna and an RF-front to receive the transmitted TDMA bursts and to transform it to an intermediate frequency (IF eg. 10.7 MHz). The adjusting device 1002 is connected to receiving device 1000 via line 1001, to the means for determining the adjusting devices control parameter 1004 via line 1003, and to means for determining the TDMA-signal's power level 1007 via lines 1005, 1006. The adjusting device 1002 may be a voltage controlled amplifier. The means for determining the TDMA-signal's power level 1007 may be a detector for rectifying and averaging the TDMA-signals ac-level. This detector 1007 is connected via line 1008 to the means for determining the control parameter 1004 which basically acts as a comparing device.

In this comparing device, e.g. an operational amplifier, the detected power level fed in via line 1008 is compared to a reference level which may be fed in via line 1009. The comparing device 1004 performs measurements of the TDMA-signal's power level and the reference level. These values are compared and the deviation from the reference value is averaged to give the control parameter of the adjusting device 1002.

The comparing device 1004 is connected via lines 1010, 1011 to at least two different time constants 1012, 1013 which are connected via lines 1014, 1015 to means 1016 for selectively switching said time constants. These switching means 1016 are connected via line 1017 to processing unit 1018 which via line 1019 connects to line 1005. The processing unit via lines 1005, 1019 detects the occurrence of a burst. preferably this is done by synchronization. The processing unit then can predict (in average) when the next burst is going to arrive. Via line 1017 and switching device 1016 the time constant is switched to the smallest value via lines 1014 before the burst is going to arrive. The comparison is then at the arrival of the burst done very quickly, that means the control parameter which is output to the adjusting device 1002 via line 1003 is rapidly adjusted to keep the TDMA-signals power level in the burst near to the reference level of line 1009. Typically the loop of adjusting device 1004 settles during the tailbits (which contain no information) of the burst. In a preferred setup the switching to a bigger time constant 1013 by the processing unit 1018 and the switching device 1016 is done after the tailbits but not earlier than the arrival of the 9^{th} bit in order to cope with problems arising from delay spread ocurring in multipath environments. The bigger time constant will cause the apparatus for fading compensation to only out-level the very slowly varying amplitude changes (fading) and not the fast changes.

Typically the bigger time constent is of the same order of magnitude as the burst duration and the order of magnitude of the smaller time constant is one order lower. With an operational amplifier preferably used as comparing device 1004 the comparison is done by integrating the difference between the detected power level and the reference level. Time constants 1012, 1013 in this case are constants of integration controlling the loop's response time.

A voltage follower is preferably included to make sure that by switching the time constants with an analog switch the same voltage for the bigger time constant as for the smaller time constant is supplied to the comparing devices so that no voltage spike will occur at the output of the operational amplifier.

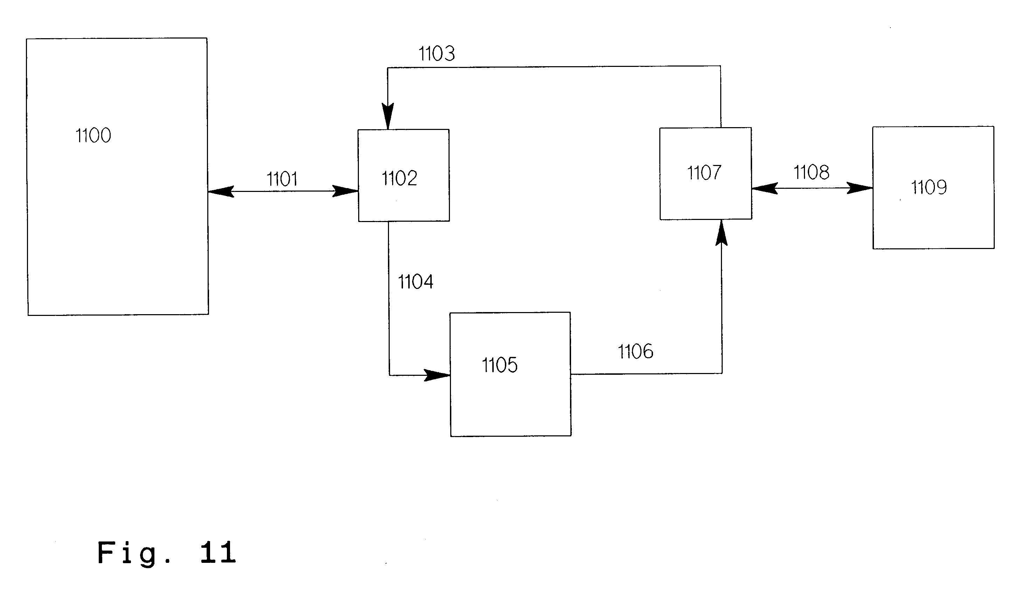

The testconfiguration shown in fig. 11 tests the receiver by transmitting a distorted signal to the receiver, and measuring the receivers ability to decode the distorted signal.

The receiver 1109 is connected to a system simulator 1100 via duplex filters 1102 and 1107 and a signaldistortion device coax-cables 1101, 1103, 1106 and 1108. The receiver under test is set in loopback mode so that the system simulator 1100 can compare the signal which it sends with the signal which is detected by the receiver 1109.

The system simulator transmitts random modulated bursts to the receiver with a power level of e.g. - 40dBm. These bursts are distorted in the distortion device 1105. The distortion could be a linear change of the power level from e.g. - 40dBm to - 102dBm through the burst. This distortion for explanatory reasons might be envisaged as a period of fading as shown for time interval t₂ in Fig. 2. After decoding in the receiver the decoded (detected) signal is transmitted to the system simulator (looped back) via the duplexfilters 1107, 1102.

A receiver with a fixed gain setting would introduce a lot of errors which would be detected by the system simulator from the looped back signal. The system simulator calculates the bit-error-rate which is a performance indication for the receiver.

A low bit error rate represents a high quality detection in the receiver of the transmitted signal. If the quality of the detection is high, most of the bits in the detected signal in the receiver 1109 have the same values as in the transmitted signal. A receiver with two time constants would show a bit-error-rate of close to zero percent while a receiver with a fixed gain setting would probably show a bit-error-rate of 5-20%.

## Claims

1. Method for fading compensation for TDMA receivers comprising the steps of: receiving a transmitted TDMA signal;
determining the occurrence of a burst of data in the received signal by a processing unit;
- detecting the power level of the received signal with a detector;
- comparing the detected power level of the received signal with a predetermined reference power level in a comparator;
- determining from said comparison a control parameter for a power adjusting device;
adjusting the received signals power level by said power adjustin device according to said control parameter;
characterized by
adjusting the received signals power level with a first, small time constant during the arrival of the first bits of the determined occurrence of a burst and adjusting the received signals power level with a second, bigger time constant after the arrival of the first bits of the determined occurrence of a burst.

2. Method according to claim 1, wherein the step of receiving a transmitted TDMA signal further includes mixing and filtering to an IF signal, characterized in that the power level of the IF signal is adjusted.

3. Method according to claim 2, characterized in that said detecting the power level and
said comparing the detected power level and
said determining of the control parameter is performed analog.

4. Method according to claim 3, characterized in that the IF signal is adjusted in a feedback loop.

5. Method according to claim 4, characterized in that the adjustment in the feedback loop is controlled by the detected power level of the IF signal.

6. Method according to claim 5, characterized in that, the step of determining the occurrence of a burst of data essentially consists of sychronizing the receiver with the transmitted TDMA signal.

7. Method according to claim 6, characterized in that, the steps of detecting the power level essentially consists of measuring the average ac-level of the IF signal.

8. Method according to claim 7, characterized in that, the steps of comparing the detected power level of the received signal with a predeterminded reference level and determining from said comparison a control parameter for a power adjusting device essentially consist of integrating the difference between the detected power level and the reference power level.

9. Method according to claim 8, characterized in that, the step of adjusting the received signals power level according to said control parameter essentially consists of a voltage controlled amplification of the IF signal.

10. Method according to claim 9, characterized in that the step of adjusting the received signals power level with a first, small time constant during the arrival of the first bits of the determined occurrence of a burst essentially consists of switching the comparator to a first, small time constant for integration as a default value after a burst has occurred.

11. Method according to 10, characterized in that the step of adjusting the received signals power level with a second, bigger time constant after the arrival of the first bits of the determined occurrence of a burst essentially consists of switching the comparator to a second, bigger time constant for integration after the by synchronisation expectable occurrence of a burst and after a by delay spread expectable period of time.

12. Method according to claim 11, characterized in that the step of switching the comparator to a second, bigger time constant for integration further includes a voltage following for the network of the second, bigger time constant after the voltage of the network for the first, small time constant.

13. Method according to claim 4, further including the steps of in-phase- and quadrature-mixing and low-pass-filtering to obtain in-phase- and quadrature-signals, characterized in that the adjustment in the feedback loop is controlled by the detected power level of the in-phase- and quadrature-signals.

14. Method according to claim 13, further including A/D conversion, characterized in that the adjustment in the feedback loop is controlled by the A/D-converted in-phase- and quadrature-signals.

15. Method according to claim 3, characterized in that the IF signal is adjusted in a feed forward loop.

16. Method according to claim 2, characterized in that said detecting the power level is performed analog, said comparing the detected power level and said determining of the control parameter is performed digitally.

17. Method according to claim 16, characterized in that the IF signal is adjusted in a feedback loop.

18. Method according to claim 17, characterized in that the adjustment in the feedback loop is controlled by the detected power level of the IF signal.

19. Method according to claim 17, further including the steps of in-phase- and quadrature-mixing and low-pass-filtering to obtain in-phase- and quadrature-signals, characterized in that the adjustment in the feedback loop is controlled by the detected power level of the in-phase- and quadrature-signals.

20. Method according to claim 19, further including A/D conversion, characterized in that the adjustment in the feedback loop is controlled by the A/D converted in-phase- and quadrature-signals.

21. Method according to claim 1, further including the steps of in-phase- and quadrature-mixing and low-pass-filtering to obtain in-phase- and quadrature-signals (baseband) characterized in that the baseband-signal is adjusted.

22. Method according to claim 21, characterized in that said detecting the power level and
said comparing the detected power level and
said determining of the control parameter are performed analog.

23. Method according to claim 22, characterized in that the analog I- and Q-signals are adjusted in a feedback loop.

24. Method according to claim 23, further including A/D conversion of the analog I- and Q-signals, characterized in that the adjustment in the feedback loop is controlled by the A/D-converted I- and Q-signals.

25. Method according to claim 22, characterized in that the I- and Q-singals are adjusted in a feed-forward loop.

26. Method according to claim 21, characterized in that said detecting the power level is performed analog,
said comparing the detected power level and
said determining of the control parameter are performed digitally.

27. Method according to claim 26, characterized in that the I- and Q-signals are adjusted in a feedback loop.

28. Method according to claim 27, further including A/D conversion of the analog I- and Q-signals, characterized in that the adjustment in the feedback loop is controlled by the A/D converted I- and Q-signals.

29. Method according to claim 26, characterized in that the I- and Q-signals are adjusted in a feed forward loop.

30. Apparatus for fading compensation for TDMA receivers comprising
means for determining the TDMA-signal's power level in a TDMA burst;
means for controllably adjusting the TDMA-signal's power level in a TDMA burst, by a control parameter;
means for determinging the time averaged control parameter from a comparison of a reference power level with values of the TDMA-signal's power level,
characterized in that,
said comparing means (1004) have selectively switchable time constants (1012, 1013) for controlling the response time of the averaging and in that
means (1016) for selectively switching said time constants are included,
so as to switch said comparing means (1004)to a first, small time constant at the arrival of a burst and to a second, bigger time constant after the arrival of the first bits of said burst.

31. Apparatus according to claim 30, characterized in that further included are means (1018) for determining the occurrence of a TDMA burst so as to control said switching to the first and the second time constant.

32. Apparatus according to claim 31 further comprising means (1000) for transforming the received TDMA signal to an intermediate frequency signal (IF).

33. Apparatus according to claim 32 wherein said means (1018) for detecting the occurrence of a TDMA burst essentially consist of means for synchronisation with a received TDMA signal.

34. Apparatus according to claim 33 wherein said means (1007) for determining the received TDMA signal's power level essentially consist of means for rectifying and averaging the TDMA signals ac-level.

35. Apparatus according to claim 34, wherein said comparing means (1004) essentially consist of means for integrating the difference between the determined power level and the reference power level.

36. Apparatus according to claim 35 wherein said means (1002) for controllably adjusting a received TDMA signal's power level essentially consist of a voltage controlled amplifier.

37. Apparatus according to claim 36 wherein said switching means (1016) for said selctively switchable time constants further include voltage following means.

38. Apparatus according to claim 37 wherein said means (1018) for determining the occurrence of a TDMA burst essentially consist of a processing unit.
